Europäisches Patentamt

European Patent Office

Office européen des brevets

(19)

(11) Veröffentlichungsnummer: **0 205 756**
**B1**

(12) **EUROPÄISCHE PATENTSCHRIFT**

(45) Veröffentlichungstag der Patentschrift: 04.07.90

(51) Int. Cl.⁵: **H 03 F 1/32**, H 03 F 1/30, H 03 F 3/58

(21) Anmeldenummer: 86102988.2

(22) Anmeldetag: 06.03.86

(54) **Arbeitspunktstabilisierter linearisierter Wanderfeldröhrenverstärker.**

(30) Priorität: 22.06.85 DE 3522408

(43) Veröffentlichungstag der Anmeldung:
30.12.86 Patentblatt 86/52

(45) Bekanntmachung des Hinweises auf die
Patenterteilung:
04.07.90 Patentblatt 90/27

(84) Benannte Vertragsstaaten:
DE FR GB

(56) Entgegenhaltungen:
EP-A-0 040 127
WO-A-84/04215
GB-A-2 060 292
US-A-4 066 965

PATENT ABSTRACTS OF JAPAN, Band 8, Nr.
123 (E-249)1560r, 8. Juni 1984; & JP-A-59 34 704
(NIPPON DENKI K.K.) 25-02-1984

(73) Patentinhaber: ANT Nachrichtentechnik GmbH
Gerberstrasse 33
D-7150 Backnang (DE)

(72) Erfinder: Radermacher, Wilhelm, Dipl.-Ing.
Im Pflästerle 63
D-7032 Sindelfingen/Maichingen (DE)
Erfinder: Czech, Johannes, Dr. Dipl.-Phys.
Richard-Wagner-Strasse 3
D-7151 Allmersbach im Tal (DE)

Courier Press, Leamington Spa, England.

**Beschreibung**

Die Erfindung betrifft einen Wanderfeldröhrenverstärker gemäß dem Oberbegriff des Patentanspruchs 1.

Zum Ausgleich der Nichtlinearitäten in Wander-feldröhrenverstärkern, die unerwünschte Inter-modulationsprodukte im Mehrträgerbetrieb ver-ursachen, werden den Wanderfeldröhrenverstär-kern üblicherweise Vorverzerrernetzwerke vorge-schaltet. Derartige Vorverzerrernetzwerke, deren Amplituden- und Phasentransfercharakteristiken invers zu den Charakteristiken der Wanderfeldröhrenverstärker verlaufen, sind beispielsweise bekannt aus EP-A-0047 825 und 5th International Conference of Digital Satellite Communications, 1981, Genua "Nonlinear Satellite Channel Design for QPSK/TDMA Transmission". Aus letztgenannter Veröffentlichung ist es außerdem bekannt, einem Vorverzerrernetzwerk ein Begrenzernet-zwerk nachzuschalten. Durch Arbeitspunktände-rungen infolge von Umgebungstemperaturände-rungen und Alterungserscheinungen wird der Linearisierungsprozeß eines solchen Wanderfeldröhrenverstärkers verschlechtert.

Aus der EP-A-0 040 127 ist ein Sendeverstärker bekannt mit einem Vorverzerrer, einem variablen Dämpfungsglied zwischen dem Vorverzerrer und einem nachgeschalteten Verstärker, einem weiteren variablen Dämpfungsglied am Eingang der Schaltung sowie einer Intermodulationsmeßvorrichtung. Das weitere variable Dämpfungsglied wird über einen Schwellwertregler gesteuert, dessen Eingangssignal vom Ausgangssignal des Verstärkers abgeleitet ist. Vom Ausgang der Intermo-dulationsmeßvorrichtung wird über einen Mikro-prozessor ein Steuersignal für das Dämpfungsglied erzeugt.

Der Erfindung liegt die Aufgabe zugrunde ausgehend vom Oberbegriff des Patentanspruchs 1, einen Wanderfeldröhren Sendeverstärker anzu-geben, welcher die Intermodulationsverzerrun-gen insbesondere bei in einem Satelliten untergebrachten Sendeverstärker auf ein gefordertes Maß begrenzt, unabhängig von der Übersteuerung, der Umgebungstemperaturänderung und der Alterung. Diese Aufgabe wird durch die kennzeichnenden Merkmale des Patentanspruchs 1 gelöst. Die Unteransprüche zeigen vorteilhafte Ausgestaltungen auf.

Die Erfindung besitzt den Vorteil, daß der Linea-risierungseffekt auch bei Übersteuerung, Tempe-raturänderungen, Alterungseffekten oder sonsti-gen Umwelteinflüssen erhalten bleibt. Außerdem wird durch die Begrenzung der Ausgangsleistung die maximal erforderliche Versorgungsleistung beschränkt. Diese Eigenschaften sind beim Einsatz des Sendeverstärkers an Bord eines Satelliten besonders wichtig.

Die Erfindung zeigt eine einfache und aufwandsgünstige Realisierung zur Verminderung von Intermodulationsverzerrungen auf. Störungen, die sich durch Maßnahmen an Bord unter-drücken lassen, beispielsweise Arbeitspunktver-schiebungen durch Temperaturänderungen, werden durch selbsttätige Regelkreise an Bord wirksam unterdrückt. Kommunikationskanäle vom und zum Satelliten werden hierdurch nicht zusätzlich belastet. Nur solche Störungen, die an Bord nicht automatisch beseitigt werden können, z.B. Alterungseffekte, werden durch Nachstellung des Sendeverstärkers mittels eines Fernsteuersignals unterdrückt.

Anhand der Zeichnungen wird die Erfindung nun näher erläutert. Es zeigen

Fig. 1 ein Blockschaltbild eines stabilisierten Sendeverstärkers,

Fig. 2 ein Blockschaltbild für einen modifizierten Sendeverstärker,

Fig. 3 den Aufbau des variablen Dämpfungsgliedes,

Fig. 4 den Aufbau des Vorverzerrers,

Fig. 5 den Aufbau des Vorverstärkers mit Begrenzer,

Fig. 6 den Aufbau der Stromversorgungsein-richtung des Wanderfeldröhren-Sendeverstär-kers.

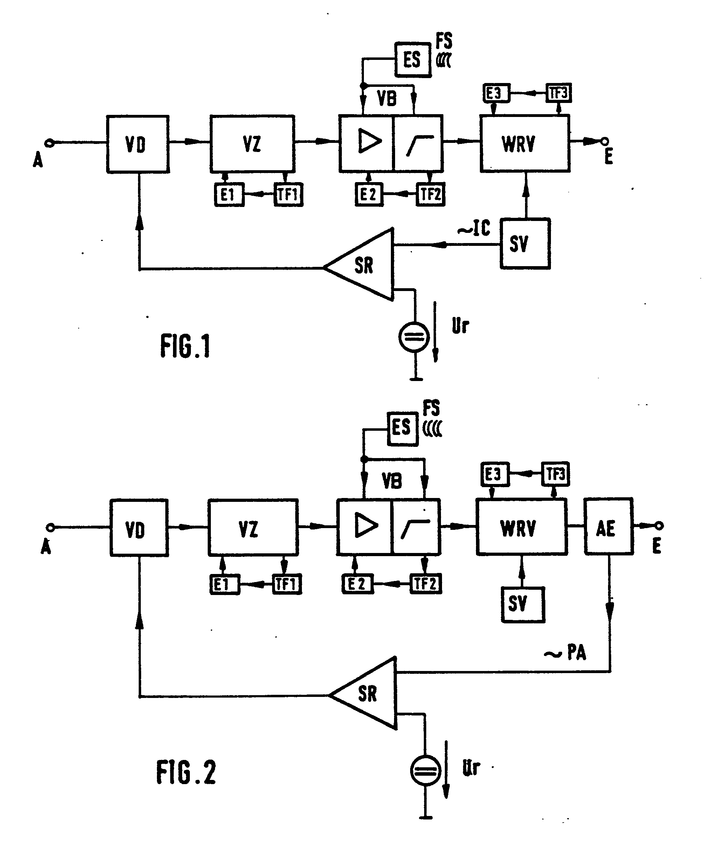

Im Blockschaltbild des Wanderfeldröhren-Sendeverstärkers zur Verwendung in einem Satelliten gemäß Fig. 1 wird ein zu verstärkendes Mehrträger-Nachrichtensignal im Gigahertz-Bereich dem Eingang A zugeführt. Über ein Dämpfungsglied VD mit einstellbarer Dämpfung α wird dieses Nachrichtensignal an einen Vorverzerrer VZ weitergeleitet. Der Aufbau dieses Vorverzerrers VZ wird im Zusammenhang mit Fig. 4 noch näher erläutert. Der Vorverzerrer VZ besitzt einen Amplituden- und Phasengang, welcher invers zum Amplituden- und Phasengang des Wanderfeldröhrenverstärkers WRV ist und somit geeignet ist, dessen nichtlineare Verzerrungen zu kompensieren. An den Vorverzerrer VZ schließt sich ein Vorverstärker mit Begrenzer VB an. Der Vorverstärker ist vorgesehen, um den Ausgangspegel des Vorverzerrers VZ an den geforderten Ein-gangspegel des Wanderfeldröhren-Sendeverstär-kers WRV anzupassen.

Der dem Vorverstärker nachgeschaltete oder in letzteren integrierte Begrenzer ist vorgesehen zur Begrenzung der Eingangsleistung des Wanderfeldröhren-Sendeverstärkers WRV, so daß die Wanderfeldröhre nicht über jenen Punkt hinaus ausgesteuert werden kann, bei dem die Ausgangsleistung niedriger zu werden beginnt. Die Stromversorgungseinrichtung SV liefert die nötigen Spannungen für die Wanderfeldröhre und den Kollektorstrom. Das linear verstärkte Mehrträger-Nachrichtensignal ist am Ausgang E verfügbar. Über die Stromversorgungseinrichtung SV wird ein Signal proportional zum Kollektorstrom IC der Wanderfeldröhre gewonnen. Der Kollektorstrom IC kann hierbei als Maß für die Ausgangsleistung angenommen werden. Über einen Schwellwertregler SR steuert das dem Kollektorstrom IC proportionale Signal das variable Dämpfungsglied VD. Der Schwellwertregler SR gibt dann ein Signal zur Erhöhung der Dämpfung α des Däm-pfungsgliedes VD ab, wenn das dem Kollektorstrom IC proportionale Signal eine dem Schwell-wertregler SR ebenfalls zugeführte Referenzspan-

nung Ur übersteigt. Bei infolge von Übersteuerungen am Signaleingang A steigendem Kollektorstrom IC und damit steigender Ausgangsleistung wird also die Dämpfung α vergrößert, was wiederum einem Ansteigen des Kollektorstromes IC entgegenwirkt. Die von der Wanderfeldröhre abgegebene und somit auch die aufgenommene Leistung wird hierdurch begrenzt. Alterungseffekte, die sich in Arbeitspunktverschiebungen (Verstärkungsänderungen) äußern, können durch eine solche Regelmaßnahme nicht ausgeglichen werden. Deshalb wird, insbesondere dem Vorverstärker oder dem nachgeschalteten Begrenzer VB, der für Eingangssignale bis zu einem bestimmten Pegel eine streng lineare Verstärkung aufweisen muß und oberhalb dieses bestimmten pegels eine möglichst ideale Begrenzerfunktion aufweisen soll, ein Fernsteuersignal FS zugeführt. Dadurch wird entweder die lineare Verstärkung des Begrenzers oder die Begrenzerschwelle unabhängig von den Alterungserscheinungen der Systemkomponenten optimal an die Wanderfeldröhren- und Vorverzerrercharakteristik angepaßt. Dieses Fernsteuersignal FS wird aufgrund einer Intermodulationsmessung anhand eines Testsignals gewonnen. Wenn der Wanderfeldröhren-Sendeverstärker ein Verstärker in einem Satelliten ist, besteht dieses Fernsteuersignal FS zweckmäßigerweise aus einem Telekommandsignal. Um die Intermodulationsmessung durchzuführen, wird ein Mehrtonsignal zum Satellitengesendet. Das durch die Bodenstation vom Satelliten empfangene jetzt verzerrte Signal wird in Bezug auf diese Verzerrungen ausgewertet. Zur Dptimierung der Einstellung des Vorverstärkers VB wird ein entsprechendes Fernsteuersignal FS an die Satellitenempfangseinrichtung ES gesendet.

Ausgewertet wird die Intermodulationsmessung mittels der Empfangseinrichtung ES des Satelliten. Die Intermodulationsmessung kann beispielsweise gemäß "IEEE Transactions on Communication Technology, Vol. COM-18, No.1, 1970, Seiten 37—48 erfolgen.

Der modifizierte Sendeverstärker gemäß Fig. 2 entspricht bis auf die Gewinnung des Eingangssignals für den Schwellwertregler SR der Schaltung nach Fig. 1. Im Gegensatz zum Ausführungsbeispiel nach Fig. 1 wird bei Fig. 2 als Eingangssignal für den Schwellwertregler SR nicht ein zum Kollektorstrom IC proportionales Signal aus der Stromversorgungseinrichtung SV entnommen, sondern es wird ein Signal verwendet, welches proportional zur Ausgangsleistung PA des Wanderfeldröhrenverstärkers WRV ist. Dieses Signal wird einer Auswerteeinrichtung AE am Ausgang des Wanderfeldröhrenverstärkers WRV entnommen. Die Auswerteeinrichtung kann beispielsweise ein Leistungsdetektor Messung des quadratischen Mittelwertes - oder ein Bolometer sein.

Zur Verminderung von Intermodulationsverzerrungen durch Temperaturänderungen weist mindestens eine der Baugruppen Vorverzerrer VZ, Vorverstärker mit Begrenzer VB, Wanderfeldröhrenverstärker WRV einen Temperaturregelkreis auf. Dazu sind diesen Baugruppen Temperaturfühler TF1, TF2, TF3 zugeordnet, die mit Einstellelementen E1, E2, E3 gekoppelt sind. Diese Einstellelemente E1, E2, E3 können beispielsweise PIN-Dioden-Dämpfungsglieder, Dual-Gate-Feldeffekttransistoren, bzw. Einrichtungen zur Arbeitspunktverstellung von Transistoren sein.

Die bis jetzt in den Figuren 1 und 2 nur prinzipiell dargestellten Baugruppen werden nun im Einzelnen in ihrer Schaltungskonfiguration dargestellt und erläutert.

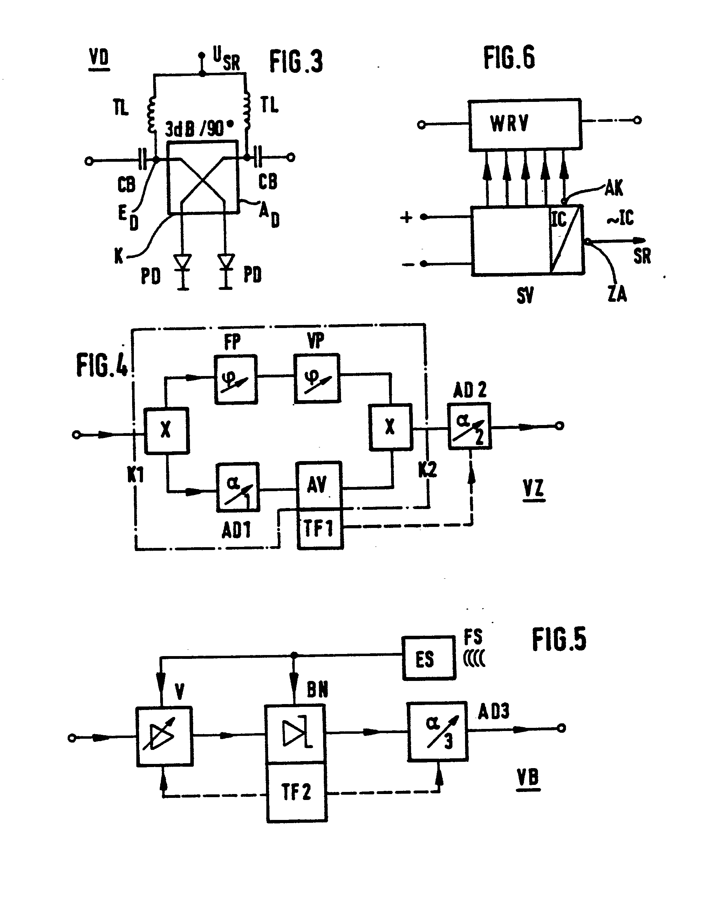

Das variable Dämpfungsglied VD besteht, wie in Fig. 3 dargestellt, aus einem 3 dB, 90°-Koppler K, der an zwei Toren mit Pin-Dioden PD abgeschlossen ist. Die beiden anderen Tore bilden Eingang $E_D$ und Ausgang $A_D$ des Kopplers. Über jeweils einen Gleichspannungsabblockkondensator $C_B$ führen diese Tore zum Ein- bzw. Ausgang des variablen Dämpfungsgliedes. Zur Einstellung der Dämpfung wird den Pin-Dioden PD jeweils über 2/4-lange Microstrip-Leitungsstücke TL, die für das RF-Signal einen Leerlauf darstellen, das Ausgangssignal $U_{SR}$ des Schwellwertreglers SR zugeführt.

Der Aufbau des Vorverzerrers VZ ist in Fig. 4 schematisch dargestellt. Er besteht aus einer Brückenschaltung mit zwei 3 dB/90°-Kopplern K1 und K2 am Ein- und Ausgang. Durch den Koppler K1 wird das Eingangssignal des Vorverzerrers auf zwei Zweige aufgespalten. Diese beiden Zweige werden mit dem Koppler K2 wieder zu einem Ausgangssignal zusammengefaßt. Im oberen Zweig, dem linearen Zweig, befindet sich die Serienschaltung aus einem Festphasenschieber FP und einem variablen Phasenschieber VP. Im unteren, dem nichtlinearen Zweig, befindet sich die Serienschaltung aus einem variablen Dämpfungsglied AD1 und einem Amplitudenverzerrer AV, der vorteilhafterweise als Backwarddioden-Netzwerk ausgebildet ist. Der bisher beschriebene Teil des Vorverzerrers VZ, in Fig. 4 strichpunktiert dargestellt, ist prinzipiell bekannt, beispielsweise aus der US-PS 4,068,186. Erfindungsgemäß ist der Amplitudenverzerrer AV mit dem Temperaturfühler TF1 gekoppelt. Bei Temperaturerhöhung des Amplitudenverzerrers AV führt der Ausgang des Temperaturfühlers TF1 ein Steuersignal, mittels dessen das dem Vorverzerrer nachgeschaltete variable Dämpfungsglied AD2 Einstellelement E1 in Fig. 1 oder 2—eingestellt werden kann. Dieses variable Dämpfungsglied AD2 kann beispielsweise aus einem Pin-Dioden-Dämpfungsglied wie in Fig. 3 bestehen oder aus Dual-Gate-Feldeffekttransistoren, bzw. aus Einrichtungen zur Arbeitspunktverstellung von Transistoren, aufgebaut sein.

Fig. 5 zeigt den prinzipiellen Aufbau des Vorverstärkers mit Begrenzer VB. Diese Einrichtung besteht aus der Serienschaltung eines Verstärkers V mit einstellbarem Verstärkungsfaktor, einem Begrenzungsnetzwerk BN mit fester oder einstellbarer Schwelle, vorzugsweise einem FET-Limiter, beispielsweise bekannt aus "Nonlinear Satellite Channel Design for QPSK/TDMA Transmission", Vth International Conference of Digital Satellite Communications, March 23—26, 1981, Genua, Italien, sowie einem variablen Dämpfungsglied AD3 Einstellelement E2 in Fig. 1 und 2 -, welches wiederum wie das Dämpfungsglied gemäß Fig. 3 aufgebaut sein kann. Dem Begrenzungsnetzwerk BN ist ein Temperaturfühler TF2 zugeordnet, der in Abhängigkeit der Temperatur des Begrenzungsnetzwerks den Dämpfungswert $a_3$ des Dämpfungsgliedes AD3 nachstellt und auch den Verstärkungsfaktor des Verstärkers mitbestimmt. Über die Satellitenempfangseinrichtung ES wird, wie zuvor geschildert, dem Verstärker V und dem Begrenzungsnetzwerk BN das Fernsteuersignal FS zugeführt.

Wie Fig. 6 zeigt, weist die Stromversorgungseinrichtung SV des Wanderfeldröhren-Sendeverstärkers WRV für das Ausführungsbeispiel gemäß Fig. 1 neben den Ausgängen für die Spannungen der Wanderfeldröhre und dem Ausgang AK für den Kollektorstrom IC einen zusätzlichen Ausgang ZA auf, der ein Signal proportional zum Kollektorstrom IC liefert und der direkt mit dem Schwellwertregler SR verbunden ist.

## Patentansprüche

1. Arbeitspunktstabilisierter linearisierter Wanderfeldröhren-Sendeverstärker, bestehend aus einem Vorverzerrer (VZ) zur Kompensation der Nichtlinearitäten des Wanderfeldröhren-Sendeverstärkers, einem dem Vorverzerrer nachgeschalteten Vorverstärker mit Begrenzer (VB) und einem dem Vorverstärker (VB) nachgeschalteten Sendeverstärker (WRV), wobei dem Vorverzerrer (VZ) ein variables Dämpfungsglied (VD) vorgeschaltet ist, welches über einen schwellwertregler (SR) gesteuert wird, wobei das Eingangssignal für den Schwellwertregler (SR) vom Ausgangssignal des Wanderfeldröhren-Sendeverstärkers (WRV) oder vom aufgenommenen Kollektorstrom des Wanderfeldröhrensendeverstärkers abgeleitet ist, und wobei dem Vorverstärker mit Begrenzer (VB) zum Ausgleich von Alterungseffekten ein Fernsteuersignal (FS) zuführbar ist, dessen Informationsgehalt durch die Auswertung einer Intermodulationsmessung bestimmt ist, dadurch gekennzeichnet, daß der Wanderfeldröhrensendeverstärker in einem Satelliten untergebracht ist, wohingegen die Intermodulationsmeßvorrichtung in einer Bodenstation angeordnet ist, und daß das Fernsteuersignal aufgrund der Intermodulationsmessung in der Bodenstation als Telekommandsignal für eine Satellitenempfangseinrichtung aufbereitbar ist.

2. Sendeverstärker nach Anspruch 1, dadurch gekennzeichnet, daß zur Temperaturregelung zusätzlich Temperaturfühler (TF1, TF2, TF3) gekoppelt mit Einstellelementen (E1, E2, E3) in mindestens einer der Baugruppen Vorverzerrer (VZ), Vorverstärker mit Begrenzer (VB), Wanderfeldröhrenverstärker (WRV) vorgesehen sind.

3. Sendeverstärker nach Anspruch 1 oder 2, dadurch gekennzeichnet, daß im Vorverzerrer (VZ) Backwarddioden zur Erzeugung der Vorverzerrung vorgesehen sind.

## Revendications

1. Amplificateur d'émission à tube à ondes progressives, linéarisé, à point de travail stabilisé, constitué par un préaccentuateur (VZ) pour compenser les non-linéarités de l'amplificateur d'émission à tube à ondes progressives, suivi d'un préamplificateur avec limiteur (VB), et par un amplificateur d'émission (WRV) monté à la suite du préamplificateur (VB), le préaccentuateur (VZ) étant précédé d'un élément atténnateur variable (VD) qui est commandé par l'intermédiaire d'un régulateur à valeur de seuil (SR), le signal d'entrée pour le régulateur à valeur de seuil (SR) étant tiré du signal de sortie de l'amplificateur d'émission à tube à ondes progressives (WRV) ou du courant de collecteur absorbé par l'amplificateur d'émission à tube à ondes progressives, et le préamplifcateur avec limiteur (VB) étant apte à recevoir, pour la compensation des effets de vieillissement, un signal de commande à distance (FS) contenant des informations déterminées par l'interprétation d'une mesure d'intermodulation, caractérisé par le fait que l'amplificateur d'émission à tube à ondes progressives est disposé dans un satellite, tandis que le dispositif de mesure d'intermodulation est disposé dans une station terrestre, et par le fait que le signal de commande à distance est préparé sur la base de la mesure d'intermodulation dans la station terrestre pour constituer un signal de télécommande pour un dispositif de réception du satellite.

2. Amplificateur d'émission selon revendication 1, caractérisé par le fait qu'en vue de la régulation de température, des capteurs de température (TF1, TF2, TF3), couplés à des éléments de réglage (E1, E2, E3) sont en outre prévus dans au moins l'un des modules préaccentuateur (VZ), préamplificateur avec limiteur (VB), amplificateur à tube à ondes progressives (WRV).

3. Amplificateur d'émission selon revendication 1 ou 2, caractérisé par le fait que des diodes unitunnel sont prévues dans le préaccentuateur (VZ), pour produire la préaccentuation.

## Claims

1. Operating point-stabilised, linearised travelling wave tube transmission amplifier, comprising a predistortion circuit (VZ) for compensation of the nonlinearities in a travelling wave tube amplifier, a preamplifier with limiter (VB) and a transmitting amplifier (WRV), both connected to the output of the predistortion circuit, with a variable attenuator (VD) being connected to the input of the predistortion circuit (VD) and being controlled via a threshold controller (SR), the input signal for the threshold controller (SR) being derived from the output signal of the travelling wave tube amplifier (WRV) or from the collector current received from the travelling wave tube transmission amplifier, and a remote control signal (FS) whose information content is determined by evaluation of an intermodulation measurement is fed to the preamplifier with limiter (VB) to compensate for aging effects, characterised in that the travelling wave tube transmission amplifier is accommodated in a satellite, while the intermodulation measuring device is disposed in a ground station and the remote control signal can be processed in the ground station on the basis of the intermodulation measurement to serve as a telecommand signal for a satellite receiving device.

2. A transmission amplifier according to claim 1, characterised in that temperature sensors (TF1, TF2, TF3) coupled with setting elements (E1, E2, E3) are additionally provided for temperature control in at least one of the predistortion circuit (VZ), the preamplifier with limiter (VB), or the travelling wave tube amplifier (WRV).

3. A transmission amplifier according to claim 1, or 2, characterised in that backward diodes are provided in the predistortion circuit (VZ) for the generation of predistortion.

FIG.1

FIG.2

FIG.3

FIG.6

FIG.4

FIG.5